Europäisches Patentamt

European Patent Office

Office européen des brevets

(11) Veröffentlichungsnummer: **0 279 490 B1**

(12) **EUROPÄISCHE PATENTSCHRIFT**

(45) Veröffentlichungstag der Patentschrift: **15.07.92**

(21) Anmeldenummer: **88200258.7**

(22) Anmeldetag: **12.02.88**

(51) Int. Cl.⁵: **C30B 29/28**, C30B 15/00

(54) **Einkristall auf Basis von Seltenerdmetall-Aluminium-Granat.**

(30) Priorität: **16.02.87 DE 3704813**

(43) Veröffentlichungstag der Anmeldung:
**24.08.88 Patentblatt 88/34**

(45) Bekanntmachung des Hinweises auf die
Patenterteilung:
**15.07.92 Patentblatt 92/29**

(84) Benannte Vertragsstaaten:
**DE FR GB NL**

(56) Entgegenhaltungen:
**EP-A- 0 170 309**

**JOURNAL OF CRYSTAL GROWTH, Band 20, 1973, Seiten 1-5, North-Holland Publishing Co., Amsterdam, NL; C.D. BRANDLE et al.: "Crystal stoichiometry and growth of rare-earth garnets containing scandium"**

**JOURNAL OF CRYSTAL GROWTH, Band 52, 1981, Seiten 542-545, North-Holland Publishing Co., Amsterdam, NL; J. KVAPIL et al.: "Czochralski growth of yag: Ce in a reducing protective atmosphere"**

(73) Patentinhaber: **Philips Patentverwaltung GmbH**
**Wendenstrasse 35 Postfach 10 51 49**
**W-2000 Hamburg 1(DE)**

(84) Benannte Vertragsstaaten:
**DE**

(73) Patentinhaber: **N.V. Philips' Gloeilampenfa-brieken**
**Groenewoudseweg 1**
**NL-5621 BA Eindhoven(NL)**

(84) Benannte Vertragsstaaten:
**FR GB NL**

(72) Erfinder: **Mateika, Dieter, Dr.**
**Seerosenstrasse 16**
**W-2087 Ellerbek(DE)**
Erfinder: **Kollewe, Dieter, Dr.**
**Viereichenweg 19**
**W-7000 Stuttgart 80(DE)**

(74) Vertreter: **Kupfermann, Fritz-Joachim, Dipl.-Ing. et al**
**Philips Patentverwaltung GmbH Wendenstrasse 35 Postfach 10 51 49**
**W-2000 Hamburg 1(DE)**

JOURNAL OF CRYSTAL GROWTH, Band 52, Teil 2, 1981, Seiten 573-575, North-Holland Publishing Co., Amsterdam, NL; P. PESHEV et al.: "Growth of single crystals of gadolinium scandium aluminium garnet by the bridgman-stockbarger method"

IEEE TRANS. NUCLEAR SCI., Band 15, Nr. 3, 1968, Seiten 95-101, New York, US; R.A. BUCHANAN et al.: "Rare earth phosphors and scintillators"

**Beschreibung**

Die Erfindung betrifft einen Einkristall auf Basis von Seltenerdmetall-Aluminium-Granat, insbesondere für die Anwendung als Szintillationskristall.

Bekannt sind viele unterschiedliche Szintillationskristalle aus z.B. anorganischen Stoffen wie Alkalihalogeniden, Cadmiumwolframat, Wismutgermanat oder organischen Stoffen wie z.B. Anthrazen, Stilben, welche zum Nachweis verschiedener Strahlungsarten eingesetzt werden. Hierzu wird beispielsweise hingewiesen auf IEEE Transactions on Nuclear Sience, Vol. NS 15 (1968), Nr. 3, Seiten 95 bis 101; IEEE Transactions on Nuclear Sience, Vol. NS 31 (1984), Nr. 1, Seiten 372 bis 376; Firmenschrift: Harshaw Radiation Detectors, Harshaw Chemie B.V., Niederlande. Dabei sind die Eigenschaften, die ein guter Szintillationskristall haben muß, in erster Linie hohe Szintillationslichtausbeute, kurze Lichtabklingdauer, mechanische Stabilität wie Unempfindlichkeit gegen Stöße, Resistenz gegen Umwelteinflüsse wie Luftfeuchtigkeit oder Lösungsmittel und das Lichtemissionsspektrum sollte außerdem gut mit der spektralen Empfindlichkeit der jeweils angeschlossenen Photomultiplier oder Photodioden übereinstimmen.

Szintillationskristalle werden zum Nachweis jeweils von niederenergetischer elektromagnetischer Strahlung (z.B. K-Röntgenstrahlung) eingesetzt, zum Nachweis höherenergetischer elektromagnetischer Strahlung (z.B. $\gamma$-Quanten) oder auch zum Nachweis von Neutronen oder geladenen Teilchen ($\alpha,\beta$-Teilchen).Für den Nachweis von $\gamma$-Quanten müssen die Kernladungszahlen der Hauptbestandteile des Kristalls und seine Dichte hoch sein, damit eine hohe Photoansprechwahrscheinlichkeit erreicht wird.

Für die Messung von Neutronen müssen in die Szintillationskristalle Elemente mit hohem Reaktionsbzw. Streuwirkungsquerschnitt für Neutronen leicht eindotierbar sein.

Die bisher in der Praxis eingesetzten Szintillationskristalle haben verschiedene Nachteile. Z.B. hat das für den Nachweis von $\gamma$-Quanten benutzte Natriumjodid, dotiert mit Thallium (NaJ:Tl), zwar eine sehr große Szintillationslichtausbeute, es ist jedoch hygroskopisch und muß immer in hermetisch dichten Gehäusen verwendet werden. Es kann daher auch nicht mit einfachen Mitteln für die Messung von $\alpha$- oder $\beta$-Teilchen eingesetzt werden. Bei NaJ-Kristallen ist der Nachweis von $\alpha$-Teilchen in Luft wegen der Absorption im Schutzgehäuse im allgemeinen nicht möglich. $\beta$-Teilchen unterliegen ähnlich wie $\alpha$-Teilchen einer Absorption in allen Materialien, jedoch ist die Reichweite von $\beta$-Teilchen größer, so daß sie dünnere Schutzgehäuse noch durchdringen können. Dies ist jedoch immer mit einem Energieverlust verbunden, so daß die Meßergebnisse verändert werden. Dadurch wird auch die niedrigste nachweisbare Energie der $\beta$-Teilchen begrenzt. In jedem Fall ist also ein Kristall ohne Schutzgehäuse auch für die Messung von $\beta$-Teilchen vorzuziehen. Außerdem ist die Lichtabklingdauer mit ca. 230 ns relativ lang und die Kristalle sind empfindlich gegen Stöße und schnelle Temperaturänderungen. Wismutgermanat, das ebenfalls als Detektor für $\gamma$-Quanten benutzt wird, hat zwar eine hohe Dichte bzw. als Hauptbestandteil das Wismut mit sehr hoher Kernladungszahl Z, jedoch ist die Szintillationslichtausbeute nicht sehr hoch (etwa 7 % derjenigen von NaJ) und die Lichtabklingdauer mit ca. 300 ns ist relativ lang. Cadmiumwolframat enthält zwar viel Wolfram mit einer hohen Kernladungszahl Z und hat eine große Dichte sowie eine relativ gute Szintillationslichtausbeute, hat aber eine lange Lichtabklingdauer zwischen 0,5 und 20 $\mu$s und als Hauptbestandteil das giftige Cadmium.

Die organischen Szintillationskristalle, die zum Nachweis von geladenen Teilchen und Neutronen benutzt werden, haben in der Regel jeweils eine sehr kurze Lichtabklingdauer, jedoch meist eine niedrige Dichte und ein niedriges Photoansprechvermögen. In Tabelle 1 sind unter anderem einige charakteristische Daten von unterschiedlichen bekannten Szintillationskristallen angegeben.

Der Erfindung liegt die Aufgabe zugrunde, Szintillationskristalle zu schaffen, die ohne zusätzliches Gehäuse einsetzbar sind und mit denen gleichzeitig niederenergetische, elektromagnetische Strahlung, wie K-Röntgenstrahlung, höherenergetische elektromagnetische Strahlung, wie $\gamma$-Quanten, sowie geladene Teilchen, wie $\alpha$-und $\beta$-Teilchen und außerdem Neutronen nachweisbar sind.

Diese Aufgabe wird erfindungsgemäß dadurch gelöst, daß der Einkristall ein Mischkristall der allgemeinen Formel $Gd_{3-x}Ce_xAl_{5-y}Sc_yO_{12}$ ist mit $0,01 < x \leq 0,1$ und $1,8 < y \leq 2,0$

Nach einer vorteilhaften Weiterbildung der Erfindung entspricht die Schmelzzusammensetzung des Kristalls der Formel $Gd_{2,97}Ce_{0,03}Al_3Sc_2O_{12}$.

Ein Verfahren zur Herstellung eines derartigen Einkristalls ist dadurch gekennzeichnet, daß die Ausgangssubstanzen für den Einkristall zunächst gemischt und trocken verpreßt und in Stickstoffatmosphäre gesintert werden, daß der Sinterkörper zur Herstellung eines Einkristalls nach dem Czochralski-Verfahren in einer abgeschlossenen Kristallziehapparatur aufgeschmolzen und daß aus dieser Schmelze ein Einkristall mit Hilfe eines Granat-Keimkristalls gezogen wird, wobei der Einkristall nach einer vorteilhaften Weiterbildung des erfindungsgemäßen Verfahrens unter reduzierender Gasatmosphäre, insbesondere einer Gasatmosphäre bestehend aus 99,95 % Stickstoff und 0,05 % Wasserstoff, gezogen wird.

Ein besonderer Vorteil der erfindungsgemäßen Szintillationskristalle ist, daß sie aufgrund ihrer mechanischen Festigkeit und Unempfindlichkeit gegen Lösungsmittel nicht mit einem mechanisch stabilen Schutzgehäuse umgeben zu werden brauchen. Dadurch können $\gamma$-Quanten, $\alpha$- und $\beta$-Teilchen sowie Neutronen ohne Abschwächung direkt in den Kristall gelangen und also auch bei Bedarf gleichzeitig gemessen werden.

Dies ist besonders wichtig für die Untersuchung von radioaktiven Abwässern und Säuren bzw. Laugen, die z.B. bei der Wiederaufbereitung radioaktiver Materialien oder in Kliniken auftreten. Hier kann der Szintillationskristall in direkten Kontakt mit der Flüssigkeit gebracht und nach dem Gebrauch leicht gereinigt werden. Analoges gilt für die Überwachung radioaktiver Gase wie Radon, Xenon u.a., die sowohl $\alpha$- als auch $\beta$-Teilchen und $\gamma$-Quanten emittieren können.

Schnelle Neutronen können mit Hilfe der z.B. aus Annalen der Physik 42 (1984), Seite 282 ff. bekannten $^{27}Al(n,\alpha_0)$ $^{24}Na$ - und $^{27}Al(n, \alpha_1)^{24m}$ Na-Reaktionen gemessen werden, während thermische Neutronen aufgrund des hohen Wirkungsquerschnittes von Gadolinium gegenüber Einfang von thermischen Neutronen nachgewiesen werden können. Szintillationskristalle gemäß der Erfindung können also gleichzeitig zum Nachweis sowohl niederenergetischer, elektromagnetischer Strahlung als auch höherenergetischer elektromagnetischer Strahlung sowie von Neutronen und geladenen Teilchen verwendet werden.

Für Szintillationskameras und Positronenemissionstomographen sind Szintillationskristalle mit einer hohen Photoansprechwahrscheinlichkeit und mit einer kurzen Lichtabklingdauer wichtig. Dadurch sind hohe Zählraten von gemessenen $\gamma$-Quanten und kleine Koinzidenzzeiten erreichbar, die wiederum eine gute Ortsauflösung ermöglichen. Bei Computertomographen kommt es besonders auf eine hohe Szintillationslichtausbeute und Stabilität gegen Driften an. Da die Kristallabmessungen wegen der angestrebten hohen Ortsauflösung sehr klein werden müssen, sollten zur Umwandlung der Strahlung in elektrische Signale vorzugsweise Photodioden verwendet werden; Photodioden zeigen vorteilhafterweise auch geringere Verstärkungsschwankungen als z.B. Photomultiplier. Deswegen ist es von Vorteil, wenn das Emissionsspektrum eines Szintillationskristalls möglichst in den Bereich der höchsten spektralen Empfindlichkeit der Photodioden fällt. Dies ist bei den erfindungsgemäßen Szintillationskristallen vergleichsweise besser der Fall als bei bekannten Szintillationskristallen. Aus der weiter unten angegebenen Tabelle ist zu entnehmen, daß nur die Jodide höhere Szintillationslichtausbeuten haben als die erfindungsgemäßen Szintillationskristalle. Bei Bestrahlung der Kristalle mit höheren Dosen entstehen, vermutlich durch Strahlenschäden, Driften in der Szintillationslichtausbeute. Der Erfindung zugrundeliegende Messungen haben gezeigt, daß Halogenide, zumindest bei der Bestrahlung mit $\alpha$-Teilchen, gegen Strahlenschäden wesentlich empfindlicher sind als Granate. Daher ist zu erwarten, daß die erfindungsgemäßen Szintillationskristalle auch kleinere Driften aufweisen als z.B die Jodide.

Insgesamt gesehen bieten die erfindungsgemäßen Szintillationskristalle eine Reihe von Vorteilen gegenüber den bekannten Szintillationskristallen, welche im Vergleich mit NaJ:Tl, dem wohl gebräuchlichsten Szintillator, noch einmal zusammengefaßt werden:

Die vorliegenden Szintillationskristalle haben eine relativ kurze Lichtabklingdauer; sie sind nicht hygroskopisch bzw. wasserlöslich und daher ist kein Schutzgehäuse nötig; $\alpha$- und $\beta$-Teilchen sind leicht meßbar; eine höhere Kernladungszahl Z bedingt eine höhere Photoansprechwahrscheinlichkeit und damit in Verbindung mit der größeren Dichte der Kristalle eine größere Nachweiswahrscheinlichkeit für höherenergetische Strahlung, was den Vorteil kleinerer Detektoren bedeutet; ihr Emissionsspektrum ist besser an die höchste spektrale Empfindlichkeit von Photodioden angepaßt; sie sind unempfindlicher gegenüber Strahlenschäden, daraus resultieren kleinere Driften; die große Unempfindlichkeit der erfindungsgemäßen Szintillationskristalle gegen Stöße und Vibrationen sowie schnelle Temperaturänderungen, gegen welche NaJ-Szintillationskristalle geschützt werden müssen, erlaubt einen Einsatz auch unter rauhen Betriebsbedingungen.

Anhand der Zeichnung wird die Erfindung in einem Ausführungsbeispiel beschrieben und in ihrer Wirkungsweise näher erläutert. Es zeigen:

Figur 1    Emissionsspektrum eines Szintillationskristalls gemäß der Erfindung,

Fig. 2    Impulshöhenspektrum eines Szintillationskristalls gemäß der Erfindung bei Bestrahlung mit einem $^{137}$Cs-Strahler,

Figur 3    Impulshöhenspektrum eines Szintillationskristalls gemäß der Erfindung bei Bestrahlung mit einem $^{241}$Am-Strahler,

Figur 4    Impulshöhenspektrum eines Szintillationskristalls gemäß der Erfindung bei gleichzeitiger Bestrahlung mit einem $^{137}$Cs-Strahler und einem $^{241}$Am-Strahler.

Als Ausführungsbeispiel wird die Züchtung eines Gadolinium-Cer-Scandium-Aluminium-Granats der Schmelzzusammensetzung $Gd_{2,97}Ce_{0,03}Al_3Sc_2O_{12}$ beschrieben. Hierbei dient Gadolinium (Kernladungszahl Z = 64) zur Erzielung eines möglichst hohen Wirkungsquerschnitts für den Photoeffekt, da dieser mit einer hohen Potenz zwischen 4 und 5 von der Kernladungszahl Z abhängt. Aluminium ist für die Erreichung einer

EP 0 279 490 B1

hohen Szintillationslichtausbeute eingeführt. Scandium dient zur Aufweitung des Kristallgitters, um den Einbau von Cer zu erleichtern. Der Dotierungsstoff Cer bestimmt ganz wesentlich die Charakteristika der Lichtemission.

Die Ausgangssubstanzen zur Herstellung des oben genannten Kristalls (132,10 g $Gd_2O_3$, 1,17 g $CeO_2$, 32,86 g $Sc_2O_3$ und 34,83 g $Al_2O_3$) werden gemischt, in Zylinderform trocken verpreßt und für 2 h bei 1400 C in Stickstoffatmosphäre gesintert.

Der Sinterkörper wird in einem induktiv beheizten Iridiumtiegel bei etwa 1850 °C in einer abgeschlossenen Kristallziehapparatur aufgeschmolzen. Durch die Apparatur wird ein Gasgemisch, bestehend aus 99,95 % Stickstoff und 0,05 % Wasserstoff, geleitet. Als Impfkristall dient ein zylinderförmiger Granateinkristallstab. Der Ziehprozeß wird in bekannter Weise nach dem Czochralski-Verfahren durchgeführt. Die Wachstumsgeschwindigkeit beträgt 2 mm/h, die Kristalldrehgeschwindigkeit 25/min. Die gezüchteten Kristalle haben eine Länge von etwa 60 mm und einen Durchmesser von etwa 20 mm. Sie sind optisch transparent und haben eine gelbe Färbung.

Für die Untersuchungen der Kristalle auf ihre Eignung als Szintillationskristalle wurden aus den Kristallen Würfel mit den Kantenlängen von $10 \times 10 \times 10$ $mm^3$ herausgeschnitten. Diese Kristallwürfel werden im folgenden als GCeScAG-Kristalle bezeichnet.

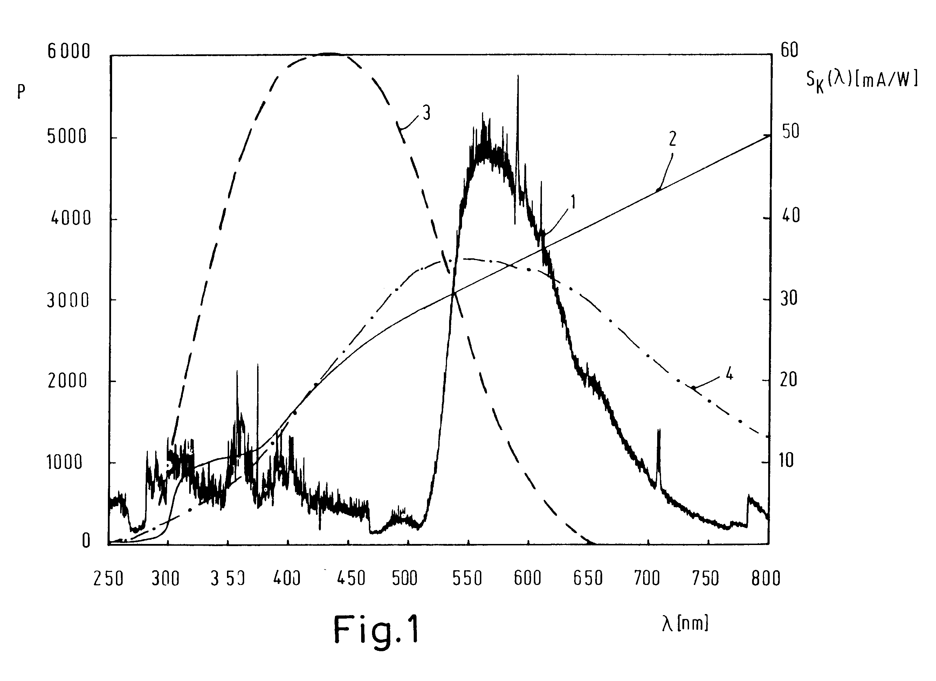

Das Emissionsspektrum eines auf die oben beschriebene Weise hergestellten GCeScAG-Kristalls wurde durch Kathodolumineszenz mit Hilfe eines Monochromators mit Einzelphotonenzählung bestimmt. Der Kristall wurde dabei mit Elektronen von etwa 40 keV Energie in einer kleinen Elektronenbeschleunigungsstrecke bestrahlt. Das Emissionsspektrum eines GCeScAG-Kristalls ist in Figur 1 dargestellt (Kurve 1). Es zeigt eine breite kontinuierliche Verteilung der Lichtintensität mit einem Maximum bei einer Wellenlänge von etwa 560 nm. In Fig. 1 ist außerdem die Wellenlänge im Vergleich mit jeweils der spektralen Empfindlichkeit $s_k$ $(\lambda)$ von im Handel erhältlichen Photokathoden und einer Photodiode dargestellt. Es bedeuten:

P :        Anzahl der Photonen pro Wellenlängenintervall (bezieht sich nur auf Kurve 1)

$s_k$ $(\lambda)$ :        Zählwirkungsgrad für Einzelphotoelektronen (%) . Wellenlänge $\lambda$ (nm) / Photoelektronenüberführungswirkungsgrad (%) . 1,24 (nach Valvo-Datenbuch "Photovervielfacher", (1983)) bezieht sich nur auf die Kurven 2 bis 4)

Kurve 2 :        Photodiode S 1790-02 von Hamamatsu; Skala für $s_k$ $(\gamma)$ ist mit Faktor 10 zu multiplizieren

Kurve 3 :        Photokathode S 11, Photomultiplier Dumont 6292

Kurve 4 :        Photokathode S 20 R, Photomultiplier Valvo XP 1017.

Aus den Kurven gemäß Figur 1 ergibt sich, daß mit dem erfindungsgemäßen Szintillationskristall auch niederenergetische Elektronen, also damit auch $\beta$-Teilchen, nachgewiesen werden können.

Die Lichtabklingdauer des erfindungsgemäßen Szintillationskristalls wurde nach Bestrahlung mit $\gamma$-Quanten aus einem radioaktiven Cäsium 137-Strahler oder mit $\alpha$-Teilchen aus einem Americium 241-Strahler direkt mit einem schnellen Oszillographen gemessen. Der Impulsanstieg ist jeweils proportional zur Lichtabklingdauer. Er beträgt etwa 100 ns für beide Strahlungsarten.

Die Lichtabklingdauer für NaJ-Szintillationskristalle ist mit etwa 230 ns wesentlich länger.

Die Szintillationslichtausbeute wurde durch Vergleich der jeweiligen Impulshöhenspektren für GCeScAG- und NaJ:Tl-Kristalle mit den im Handel erhältlichen Photomultipliern Valvo XP 1017 und Dumont 6292 bestimmt. Hierzu wurden die Kristalle mit einem radioaktiven $^{137}$Cs-Strahler bestrahlt. Bei Benutzung des Photomultipliers Dumont 6292 betrug die Szintillationslichtausbeute 7 % derjenigen von NaJ:Tl, während bei Verwendung des Photomultipliers Valvo XP 1017 eine Szintillationslichtausbeute von mehr als 36 %, bezogen auf NaJ:T1, gemessen wurde. Die vergleichsweise höhere Lichtausbeute bei Anwendung des Photomultipliers Valvo XP 1017 erklärt sich aus seiner weiter zu längeren Wellenlängen verschobenen spektralen Empfindlichkeit, welche dem Emissionsspektrum des Granats besser angepaßt ist. Unter Berücksichtigung der verschiedenen Größen der spektralen Empfindlichkeit für die Maxima der Emissionsspektren von NaJ:Tl und GCeScAG ergibt sich eine relative Lichtausbeute für GCeScAG von ca. 20 % bezogen auf NaJ:Tl (100 %) bei beiden Photomultipliern.

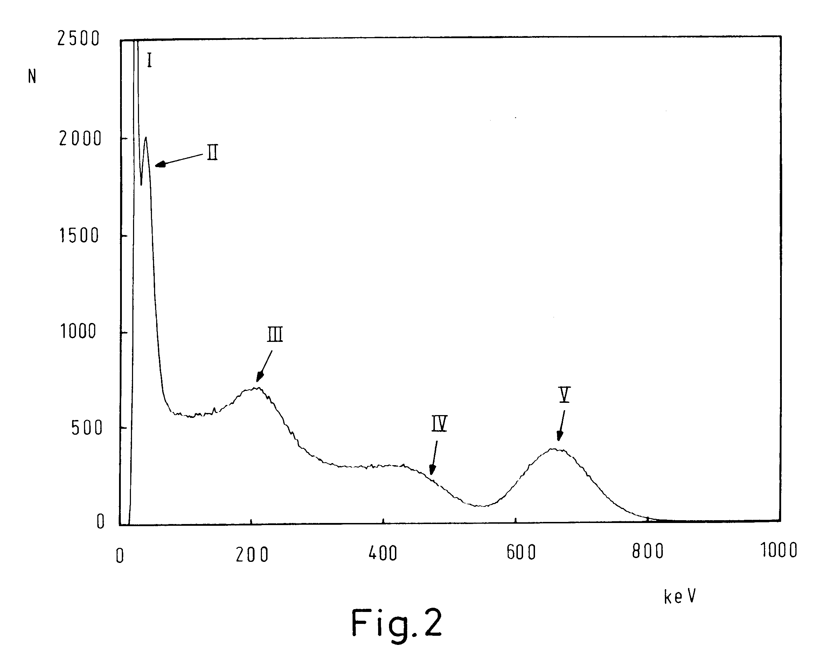

Figur 2 zeigt das gemessene Impulshöhenspektrum des erfindungsgemäßen Szintillationskristalls bei Bestrahlung mit einem $^{137}$Cs-Strahler. Ein solcher Strahler emittiert sowohl $\beta$-Teilchen und Konversionselektronen als auch $\gamma$-Quanten mit einer Energie von 662 keV, sowie charakteristische K-Röntgenstrahlung von $^{137}$Ba, dem Tochterkern von [137]Cs. Die $\beta$-Teilchen und die Konversionselektronen wurden abgeschirmt, da nur elektromagnetische Strahlung in Form von $\gamma$-Quanten und K-Röntgenstrahlung gemessen werden sollten.

In der Figur bedeuten N = Anzahl der Impulse pro Kanal, wobei ein Kanal 2 keV Energie entspricht. Das erste große Maximum I ist durch das Rauschen des Photomultipliers bedingt, das zweite Maximum II durch die K-Röntgenlinien von $^{137}$Ba, dem Tochterkern von $^{137}$Cs; weitere signifikante Charakteristika des

5

Spektrums sind das Rückstreumaximum III (Nachweislinie der vom Glas des Photomultipliers rückgestreuten $\gamma$-Quanten), die Comptonkante IV und das Photomaximum V (maximale Lichtausbeute der $\gamma$-Quanten einer Energie von 662 keV). Wie Fig. 2 zeigt, können sowohl die verhältnismäßig niederenergetische K-Röntgenstrahlung des $^{137}$Ba mit einer Energie von 32 keV als auch die höherenergetischen $\gamma$-Quanten mit einer Energie von 662 keV gemessen werden.

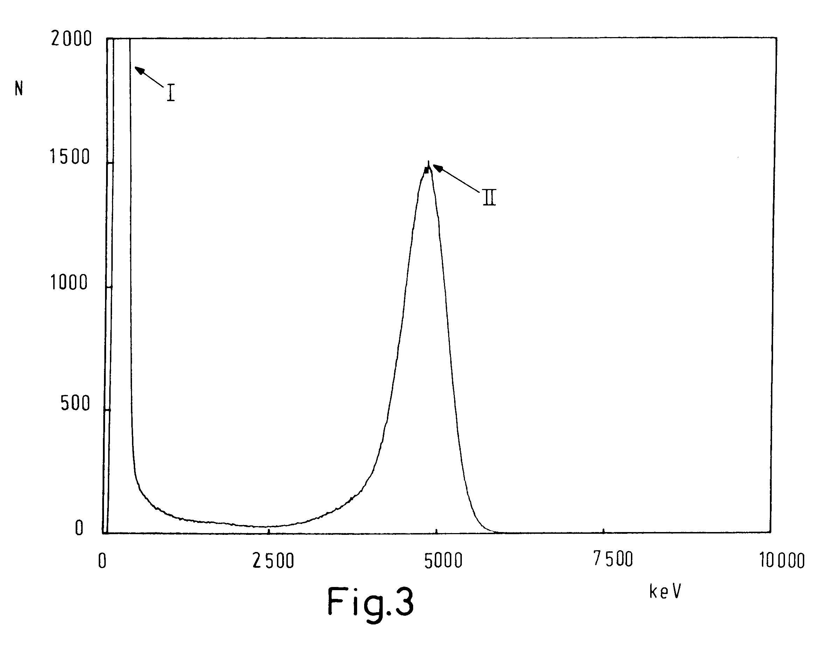

Figur 3 zeigt das Impulshöhenspektrum eines GCeScAG-Kristalls, gemessen an Luft, für $\alpha$-Teilchen aus einem $^{241}$Am-Strahler. Das Energieauflösungsvermögen für die Photolinie der 662 keV- $\gamma$-Strahlung betrug ebenso wie für die $\alpha$-Strahlung 16 %. Es wurde der Valvo-Photomultiplier XP 1017 eingesetzt, der Abstand des $^{241}$Am-Strahlers von der Oberfläche des Szintillationskristalls betrug 2 mm. Das erste große Maximum I ist wieder durch das Rauschen des Photomultipliers bedingt, das zweite Maximum II entspricht der Gesamtenergie der $\alpha$-Teilchen.

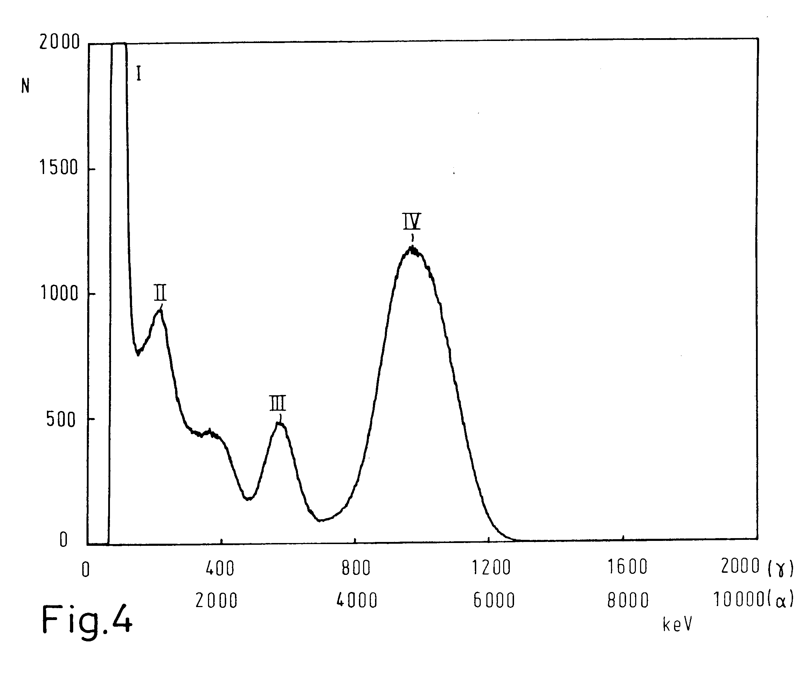

Fig. 4 zeigt das Impulshöhenspektrum eines GCeScAG-Kristalls bei gleichzeitiger Bestrahlung mit einem $^{137}$Cs-Strahler und einem $^{241}$Am-Strahler. Das erste große Maximum I ist durch das Rauschen des Photomultipliers bedingt, weitere Charakteristika des Spektrums sind das Rückstreumaximum II (Nachweislinie der vom Glas des Photomultipliers rückgestreuten $\gamma$-Quanten), das Photomaximum III (maximale Lichtausbeute der $\gamma$-Quanten einer Energie von 662 keV) und das der der Gesamtenergie der $\alpha$-Teilchen entsprechende Maximum IV. Die unterschiedlichen Werte der Energien erklären sich daraus, daß die Lichtausbeute für $\alpha$-Teilchen etwa um den Faktor 5 niedriger ist als für $\gamma$-Quanten. Dies ist ähnlich wie bei bekannten Szintillatoren.

In der nachfolgenden Tabelle sind charakteristische Eigenschaften bekannter Szintillationskristalle und des erfindungsgemäßen GCeScAG-Szintillationskristalls dargestellt.

Charakteristische Eigenschaften von Szintillatoren

| | NaJ:Tl | CsJ:Tl | Bi$_4$Ge$_3$O$_{12}$ | CdWO$_4$ | ZnWO$_4$ | BaF$_2$ | Gd$_3$Sc$_2$Al$_3$O$_{12}$:Ce |
|---|---|---|---|---|---|---|---|
| Kristallstruktur | kubisch | kubisch | kubisch | monoklin | monoklin | kubisch | kubisch |
| Schmelzpunkt (°C) | 651 | 621 | 1050 | 1325 | 1200 | 1280 | ≈ 1850°C |
| Dichte (g/cm$^3$) | 3,67 | 4,52 | 7,13 | 7,99 | 7,87 | 4,88 | 5,76 |
| Löslichkeit (g/100 g H$_2$O) | 185,0 | 85,5 | - | 0,05* | - | 0,12* | - |
| Mohs-Härte | 2,0 | 2,0 | 5,0 | 4,0-4,5 | | | ≈ 8 |
| Wellenlänge des Maximums der Emission (nm) | 415 | 530 | 485 | 480 | 480 | 325 | 565 |
| Lichtausbeute bei 60 keV (%) | 100 | 85 | 7 | 17 | 14 | 10 | ≈ 20 |
| Lichtabklingdauer (µs) | 0,23 | 0,98 | 0,3 | 8,9 | 21,8 | 0,63 | 0,1 |

Daten für NaJ:Tl bis ZnWO$_4$ nach: IEEE Transact. on Nuclear Science, Vol. NS-31, (1984), Nr. 1, S. 372-376

BaF$_2$ nach: Firmenschrift Harshaw Radiation Detectors, Harshaw Chemie B.V., Niederlande

* nach: Handbook of Chemistry and Physics, 53 rd Edition, 1973, The Chemical Rubber Co, USA

**Patentansprüche**

1. Einkristall auf Basis von Seltenerdmetall-Aluminium-Granat,
dadurch gekennzeichnet,

daß der Einkristall ein Mischkristall der allgemeinen Formel $Gd_{3-x}Ce_xAl_{5-y}Sc_yO_{12}$ ist
mit $0,01 < x \leq 0,1$
$1,8 < y \leq 2,0$.

**2.** Einkristall nach Anspruch 1,
dadurch gekennzeichnet,
daß seine Schmelzzusammensetzung der Formel $Gd_{2,97}Ce_{0,03}Al_3Sc_2O_{12}$ entspricht.

**3.** Verfahren zur Herstellung eines Einkristalls nach den Ansprüchen 1 und 2,
dadurch gekennzeichnet,
daß die Ausgangssubstanzen für den Einkristall zunächst gemischt und trocken verpreßt und in Stickstoffatmosphäre gesintert werden, daß der Sinterkörper zur Herstellung eines Einkristalls nach dem Czochralski-Verfahren in einer abgeschlossenen Kristallziehapparatur aufgeschmolzen und daß aus dieser Schmelze ein Einkristall mit Hilfe eines Granat-Keimkristalls gezogen wird.

**4.** Verfahren nach Anspruch 3,
dadurch gekennzeichnet,
daß der Einkristall unter reduzierender Gasatmosphäre gezogen wird.

**5.** Verfahren nach Anspruch 4,
dadurch gekennzeichnet,
daß der Einkristall unter einer Gasatmosphäre bestehend aus 99,95 % Stickstoff und 0,05 % Wasserstoff gezogen wird.

**6.** Verwendung des Einkristalls nach den Ansprüchen 1 und 2 als Szintillationskristall.

**Claims**

**1.** A single crystal on the basis of rare earth metal-aluminium-garnet, characterized in that tlle single crystal is a mixed crystal of the general formula $Gd_{3-x}Ce_xAl_{5-y}Sc_yO_{12}$, where
$0.01 < x \leq 0.1$ and
$1.8 < y \leq 2.0$.

**2.** A single crystal as claimed in Claim 1, characterized in that the melt composition complies with the formula $Gd_{2.97}Ce_{0.03}Al_3Sc_2O_{12}$.

**3.** A method of manufacturing a single crystal as claimed in Claims 1 and 2, characterized in that the starting substances of the single crystal are first mixed and compressed in a dry state after which they are sintered in a nitrogen atmosphere, and in that to produce a single crystal the sintered body is melted according to the Czochralski-method in a closed crystal pulling device, and that a single crystal is pulled from the melt by means of a garnet seed crystal.

**4.** A method as claimed in Claim 3, characterized in that the single crystal is pulled in a reducing gas atmosphere.

**5.** A method as claimed in Claim 4, characterized in that the single crystal is pulled in a gas atmosphere consisting of 99.95% of nitrogen and 0.05 % of hydrogen.

**6.** The use of the single crystal as claimed in Claims 1 and 2 as a scintillation crystal.

**Revendications**

**1.** Monocristal à base de grenat d'aluminium-métal des terres rares, caractérisé en ce que le monocristal est un cristal mixte répondant à la formule générale $Gd_{3-x}Ce_xAl_{5-y}Sc_yO_{12}$ avec $0,01 < x \leq 0,1$ et
$1,8 < y \leq 2,0$.

**2.** Monocristal selon la revendication 1, caractérisé en ce que la composition de fusion du cristal répond à la formule $Gd_{2,97}Ce_{0,03}Al_3Sc_2O_{12}$.

**3.** Procédé dur la réalisation d'un monocristal selon les revendications 1 et 2, caractérisé en ce que les substances de départ pour le monocristal sont d'abord mélangées et comprimées à l'état sec et frittées dans une atmosphère d'azote, en ce que pour la réalisation d'un monocristal le corps fritté est d'abord fondu selon le procédé Czochralski dans un appareillage à tirage de cristaux fermé et qu'à partir de ce bain est étiré un monocristal à l'aide d'un germe cristallin de grenat.

**4.** Procédé selon la revendication 3' caractérisé en ce que le monocristal est tiré dans une atmosphère gazeuse réductrice.

**5.** Procédé selon la revendication 4, caractérisé en ce que le monocristal est tiré dans une atmosphère gazeuse constituée par 99,95% d'azote et 0,05 d'hydrogène.

**6.** Application du monocristal selon les revendications 1 et 2, comme cristal de scintillation.

Fig.1

Fig.2

Fig.3

Fig.4